# EUROPEAN PATENT APPLICATION

(11) **EP 2 306 241 A2**
(43) Date of publication of application: **06.04.2011**
(21) Application number: 10186423.9
(22) Date of filing: 04.10.2010
(51) Int. Cl.: G03F 1/14

(54) **Pellicle**

(30) Priority: 02.10.2009 JP 2009230433
(71) Applicant: Shin-Etsu Chemical Co., Ltd., Chiyoda-ku, Tokyo (JP)
(72) Inventor: Shirasaki, Toru, Annaka-shi, Gunma (JP); Tuskada, Junichi, Annaka-shi, Gunma (JP)
(74) Representative: Vossius & Partner

(57) **Abstract**

A pellicle for lithography is provided that includes a pellicle frame, a pellicle film stretched over one end face of the pellicle frame, and a pressure-sensitive adhesion layer provided on the other end face, the pressure-sensitive adhesion layer being formed from a gel composition.

## Description

The present invention relates to a pellicle for lithography used as a debris shield for a lithography mask when producing a semiconductor device such as an LSI or a ULSI or a liquid crystal display panel.

In the production of a semiconductor such as an LSI or a ULSI or the production of a liquid crystal display panel, a pattern is formed by irradiating a semiconductor wafer or a liquid crystal master plate with light; if debris is attached to an exposure master plate, since the debris absorbs the light or refracts the light, there are problems that the replicated pattern is deformed, the edges become rough, or the background is stained black, thus impairing the dimensions, quality, appearance, etc. The 'exposure master plate' referred to in the present invention is a general term for lithography masks (also called simply 'masks') and reticles. The explanation below is given for a mask as an example.

These operations are usually carried out in a clean room, but even within a clean room it is difficult to always keep the exposure master plate clean, and a method is therefore employed in which a pellicle film that allows exposure light to easily pass through is affixed to the surface of the exposure master plate to act as a debris shield.

The pellicle is basically constituted of a pellicle frame and a pellicle film stretched over the frame. The pellicle film is formed from nitrocellulose, cellulose acetate, a fluorine-based polymer, etc., which allows exposure light (g rays, i rays, 248 nm, 193 nm, etc.) to easily pass through. The pellicle film is adhered by coating the upper end part of the pellicle frame with a good solvent for the pellicle film and air-drying or by means of an adhesive such as an acrylic resin, an epoxy resin, or a fluorine resin. Furthermore, in order to mount an exposure master plate, the lower end part of the pellicle frame is provided with a pressure-sensitive adhesion layer made of a polybutene resin, a polyvinyl acetate resin, an acrylic resin, a silicon resin, etc. and a reticle pressure-sensitive adhesive protecting liner for the purpose of protecting the pressure-sensitive adhesive layer.

The pellicle is installed so as to surround a pattern region formed on the surface of the exposure master plate. Since the pellicle is provided in order to prevent debris from becoming attached to the exposure master plate, this pattern region and a pellicle outer part are separated so that dust from the pellicle outer part does not become attached to the pattern face.

In recent years, the LSI design rule has shrunk to sub-quarter micron, and accompanying this the wavelength of the exposure light source is being shortened, that is, instead of g rays (436 nm) and i rays (365 nm) from the hitherto predominant mercury lamp, a KrF excimer laser (248 nm), an ArF excimer laser (193 nm), etc. are being used. As shrinkage advances, the flatness required for the mask and silicon wafer becomes more strict.

A pellicle is affixed to a mask in order to shield the pattern from debris after the mask is completed. When a pellicle is affixed to the mask, the mask flatness can sometimes change. When the mask flatness is degraded, as described above there is the possibility that problems such as defocusing will occur. Furthermore, when the flatness changes, the pattern shape drawn on the mask changes, and this brings about the difficulty that problems occur with the precision of superimposition of the mask.

There are several factors involved in the change in mask flatness due to a pellicle being affixed, but it has been found that the largest factor is the flatness of the pellicle frame.

The pellicle is affixed to a mask via a mask pressure-sensitive adhesive present on one side of the pellicle frame; when the pellicle is affixed to a mask, the pellicle is usually pressed against the mask with a force of in the order of 20 to 30 kgf. In general, the flatness of the mask is a few µm or less as a TIR value, and is 1 µm or less for a state-of-the-art mask, and the flatness of the pellicle frame is generally in the order of a few tens of µm, which is large compared with the mask. Because of this, when the pellicle is affixed to the mask, the flatness of the mask might change due to unevenness of the frame. Here, it could be thought that by increasing the flatness of the pellicle frame so that it is as high as the flatness of the mask it would become possible to reduce the change in flatness of the mask.

The pellicle frame is generally formed from an aluminum alloy. With regard to a pellicle frame for semiconductor lithography, the width is in the order of 150 mm, the length is in the order of 110 to 130 mm, and it is generally formed from a pellicle frame bar having a rectangular cross-section. A frame is generally prepared by cutting out a pellicle frame shape from an aluminum alloy plate or by extrusion-molding an aluminum material into a frame shape, but since the width is as narrow as in the order of 2 mm and it is easy to deform, it is not easy to produce a flat frame. Because of this, it is very difficult to make the pellicle frame have a flatness of the same degree as that of the mask.

In order to prevent deformation of the mask due to deformation of the pellicle frame, JP-A-2008-65258 discloses a pellicle in which the thickness of a mask pressure-sensitive adhesive via which the pellicle is affixed to a mask is at least 0.4 mm, and a pellicle for which the modulus of elasticity at 23°C of the mask pressure-sensitive adhesive is no greater than 0.5 MPa.

In recent years, with regard to the flatness required for a mask, from a flatness of 2 µm on the pattern face the requirement is gradually becoming more strict, and for the 65 nm node process and beyond, 0.5 µm or less and preferably 0.25 µm is now required.

In general, the flatness of a pellicle frame is in the order of 20 to 80 µm, but if a pellicle employing a pellicle frame having poorer flatness than the mask is affixed to the mask, the shape of the frame is transferred to the mask, thus causing deformation in the mask. When affixing, the pellicle is pressed against the mask with a large force of about 200 to 400 N (20 to 40 kgf). Since the flatness of the mask surface is better than the flatness of the pellicle frame, when pressing of the pellicle against the mask is completed, the pellicle frame attempts to return to its original shape, and the pellicle frame thereby causes the mask to deform.

When the mask is deformed, the mask flatness can sometimes be degraded, and in this case the problem of defocusing within an exposure device occurs. On the other hand, deformation of the mask can sometimes improve the flatness, but even in this case a pattern formed on the mask surface is distorted, and as a result the problem that a pattern image replicated on a wafer by exposure being distorted occurs. Since this distortion of the pattern also occurs when the mask flatness is degraded, when the mask ends up being deformed by affixing the pellicle, the problem of the pattern image being distorted always occurs.

It is an object of the present invention to provide a pellicle for lithography that can suppress deformation of an exposure master plate due to deformation of the pellicle frame even if a pellicle is affixed to the exposure master plate.

The above-mentioned objects of the present invention have been accomplished by means (1) below. They are described together with (2) to (9), which are preferred embodiments.
(1) A pellicle for lithography comprising: a pellicle frame; a pellicle film stretched over one end face of the pellicle frame; and a pressure-sensitive adhesion layer provided on the other end face, the pressure-sensitive adhesion layer comprising a gel composition,
(2) The pellicle according to (1), wherein the gel composition has a 1/4 cone penetration in accordance with ASTM D-1403 of at least 50 but no greater than 100,
(3) The pellicle according to (1) or (2), wherein the pressure-sensitive adhesion layer has a thickness of at least 0.3 mm but no greater than 0.8 mm,
(4) The pellicle according to any one of (1) to (3), wherein the pressure-sensitive adhesion layer has a thickness of 0.3 to 0.5 mm,
(5) The pellicle according to any one of (1) to (4), wherein the gel composition is a synthetic polymer gel composition,
(6) The pellicle according to any one of (1) to (5), wherein the gel composition comprises a silicone polymer gel or a urethane polymer gel,
(7) The pellicle according to (6), wherein the gel composition comprises a silicone polymer gel,
(8) The pellicle according to any one of (1) to (7), wherein the gel composition comprises a two-component silicone polymer gel or urethane polymer gel,
(9) The pellicle according to any one of (1) to (8), wherein the pellicle frame comprises an aluminum alloy.

In accordance with the present invention, by the use of press ure-sensitive adhesion layer comprising a flexible gel composition as the pellicle pressure-sensitive adhesion layer, distortion of a mask, etc. when affixing the pellicle to the mask, etc. can be reduced. Because of this, deformation of an exposure master plate due to deformation of the pellicle frame can be minimized. A pattern drawn above the mask can thereby be reproduced with more precision, thereby improving the mask overlay accuracy.

### Brief Description of Drawings

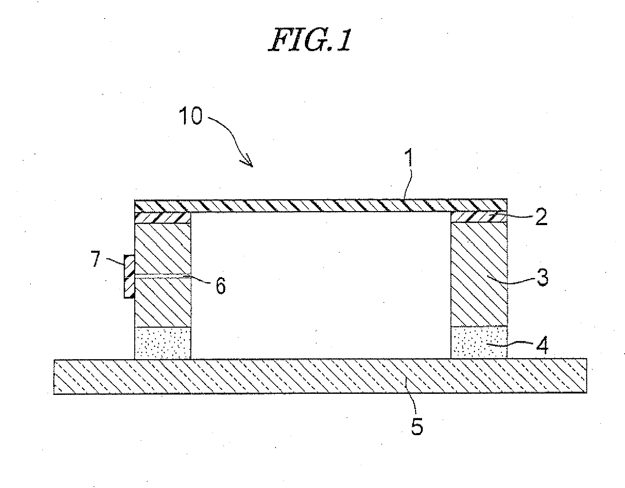

FIG. 1 A schematic diagram showing the basic constitution of a pellicle used in the present invention.

### Explanation of Reference Numerals and Symbols

1: Pellicle film
2: Adhesion layer
3: Pellicle frame
4: Pressure-sensitive adhesion layer
5: Exposure master plate
6: Atmospheric pressure adjustment hole (vent)
7: Dust filter
10: Pellicle
(The pressure-sensitive adhesion layer comprising a gel composition)

The basic constitution of the pellicle used in the present invention is explained first by reference to FIG. 1.

FIG. 1 is a schematic diagram showing the basic constitution of a pellicle used in the present invention.

As shown in FIG. 1, a pellicle 10 of the present invention is formed by stretching a pellicle film 1 over an upper end face of a pellicle frame 3 via an adhesive layer 2 for affixing the pellicle film. In this case, a pressure-sensitive adhesion layer 4 comprising a gel composition for adhering the pellicle 10 to an exposure master plate (mask substrate or reticle) 5 is usually formed on the lower end face of the pellicle frame 3, and a liner (not illustrated) is detachably adhered to the lower end face of the pressure-sensitive adhesion layer 4. The pellicle frame 3 may be provided with an atmospheric pressure adjustment hole (vent) 6, and further with a dust filter 7 for the purpose of removing particles.

The dimensions of these pellicle constituent members are similar to those of a normal pellicle, for example, a pellicle for semiconductor lithography, a pellicle for a lithographic step of large liquid crystal display panel production, etc., and the materials thereof may be known materials.

The type of pellicle film is not particularly limited and, for example, an amorphous fluorine polymer, etc. that has conventionally been used for an excimer laser is used. Examples of the amorphous fluorine polymer include Cytop (product name, manufactured by Asahi Glass Co. Ltd.) and Teflon (Registered Trademark) AF (product name, manufactured by DuPont). These polymers may be used by dissolving them in a solvent as necessary when preparing the pellicle film, and may be dissolved as appropriate in, for example, a fluorine-based solvent.

With regard to the base material of the pellicle frame, a conventionally used aluminum alloy material, and preferably a JIS A7075, JIS A6061, JIS A5052 material, etc., is used, but when an aluminum alloy is used it is not particularly limited as long as the strength as a pellicle frame is guaranteed. The surface of the pellicle frame is preferably roughened by sandblasting or chemical abrasion prior to providing a polymer coating. In the present invention, a method for roughening the surface of the frame may employ a conventionally known method. It is preferable to employ a method for roughening the surface involving blasting the aluminum alloy material surface with stainless steel, carborundum, glass beads, etc., and further by chemically abrading with NaOH, etc.

As a gel composition forming the pressure-sensitive adhesion layer 4, a gel composition of various types of synthetic polymers resulting from addition-polymerization or condensation-polymerization may be used and, for example, a silicone polymer gel or a urethane polymer gel may preferably be used. The pressure-sensitive adhesion layer 4 may be formed by coating an end face of the pellicle frame 3 with a two-component silicone polymer gel or urethane polymer gel, which cures by mixing of a main component and a crosslinking agent, followed by curing. Furthermore, the pressure-sensitive adhesion layer 4 may be formed by adhering a silicone gel sheet, cut so as to match the width of the end face of the pellicle frame 3, to the end face of the pellicle frame 3.

The pellicle for lithography of the present invention is characterized by a layer for pressure-sensitive adhesion to an exposure master plate (in the present invention, also called simply a 'pressure-sensitive adhesion layer') comprising a gel composition.

The pressure-sensitive adhesion layer preferably has a 1/4 cone penetration in accordance with ASTM D-1403 of at least 50, and more preferably 50 to 100. By setting the penetration of the pressure-sensitive adhesion layer in the range of 50 to 100, the pressure-sensitive adhesion layer can sufficiently absorb distortion of the pellicle frame while maintaining the configuration of the pressure-sensitive adhesion layer. Deformation of an exposure master plate due to deformation of the pellicle frame can thereby be sufficiently suppressed.

The thickness of the pressure-sensitive adhesion layer is preferably at least 0.3 mm, more preferably 0.3 to 0.8 mm, and particularly preferably 0.3 to 0.5 mm. By setting the thickness of the pressure-sensitive adhesion layer in the above-mentioned range, even if a pellicle having poor flatness is affixed, it is possible to prevent the good flatness of an exposure master plate from being degraded.

### Examples

The present invention is explained below more specifically by reference to Examples. A 'mask' in the Examples and Comparative Example is illustrated as an example of the 'exposure master plate' and, needless to say, application to a reticle can be carried out in the same manner.

### (Example 1)

An aluminum alloy pellicle frame (external dimensions 149 mm × 113 mm × 4.5 mm, thickness 2 mm, flatness on the pressure-sensitive adhesive layer side 30 µm) was washed with pure water, an end face thereof was coated with a silicone polymer gel (product name: KE-1051J) manufactured by Shin-Etsu Chemical Co., Ltd., and cured, thus forming a pressure-sensitive adhesion layer. Specifically, liquid A and liquid B of KE-1051J were mixed at a mixing ratio of 1:1 and placed in a syringe, coating was carried out using a dispenser, and subsequently curing was carried out at a curing temperature of 150°C for a curing time of 10 min. The cured KE-1051J had a 1/4 cone penetration in accordance with ASTM D-1403 of 65. The thickness of the cured KE-1051J was 0.3 mm.

Subsequently, the face of the pellicle frame opposite to the pressure-adhesive face was coated with a Cytop adhesive (product name: CTX-A) manufactured by Asahi Glass. Following this, the pellicle frame was heated at 130°C, thus curing the adhesive.

Following this, the adhesive side of the above pellicle frame was affixed to a pellicle film provided on an aluminum framework that was larger than the pellicle frame, and portions outside the pellicle frame were removed, thus completing pellicle 1.

When this pellicle 1 was affixed to a mask having a flatness of 0.20 µm, the flatness of the mask changed to 0.23 µm. The amount of change in the flatness of the mask after affixing the pellicle was a low value of 0.03 µm, this being a good result. The results thus obtained are shown in Table 1.

### (Example 2)

Pellicle 2 was completed in the same manner as in Example 1 except that the silicone polymer gel used in Example 1 was changed, and a silicone polymer gel (product name: X-32-1268) manufactured by Shin-Etsu Chemical Co., Ltd. was used.

The mixing ratio of liquid A and liquid B of X-32-1268 was 1:1, and curing conditions were a curing time of 10 min and a curing temperature of 150°C. The cured X-32-1268 had a 1/4 cone penetration in accordance with ASTM D-1403 of 95. The thickness of the cured X-32-1268 was 0.3 mm.

When this pellicle 2 was affixed to a mask having a flatness of 0.20 µm, the flatness of the mask did not change and remained at 0.20 µm, this being very good result. The results thus obtained are shown in Table 1.

### (Example 3)

Pellicle 3 was completed in the same manner as in Examples 1 and 2 except that, unlike Examples 1 and 2, a urethane polymer gel (product name: Pandex GCA-11/GCB-41) manufactured by DIC was used instead of the silicone polymer gel.

The mixing ratio of Pandex GCA-11/GCB-41 was 100:12.5, and curing conditions were a curing time of 30 min and a curing temperature of 100°C. The cured Pandex GCA-11/GCB-41 had a 1/4 cone penetration in accordance with ASTM D-1403 of 55. The thickness of the cured Pandex GCA-11/GCB-41 was 0.5 mm.

When this pellicle 3 was affixed to a mask having a flatness of 0.20 µm, the flatness of the mask changed to 0.22 µm. The amount of change in the flatness of the mask after affixing the pellicle was a low value of 0.02 µm, this being a good result. The results thus obtained are shown in Table 1.

### (Example 4)

Pellicle 4 was completed in the same manner as in Example 1 except that the conditions of Example 1 were changed so that the cured KE-1051J had a 1/4 cone penetration in accordance with ASTM D-1403 of 45. The thickness of the cured KE-1051J was 0.3 mm.

When this pellicle 4 was affixed to a mask having a flatness of 0.20 µm, the flatness of the mask changed to 0.30 µm. The amount of change in the flatness of the mask after affixing the pellicle was a low value of 0.10 µm. The results thus obtained are shown in Table 1.

**(Table 1)**

| Example | Penetration | Thickness (mm) | Flatness of mask (µm) | | |
|---|---|---|---|---|---|
| | | | Before | After affixing the pellicle | Amount of change |
| 1 | 65 | 0.3 | 0.20 | 0.23 | 0.03 |
| 2 | 95 | 0.3 | 0.20 | 0.20 | 0.00 |
| 3 | 55 | 0.5 | 0.20 | 0.22 | 0.02 |
| 4 | 45 | 0.3 | 0.20 | 0.30 | 0.10 |

## Claims

1. A pellicle for lithography comprising: a pellicle frame; a pellicle film stretched over one end face of the pellicle frame; and a pressure-sensitive adhesion layer provided on the other end face, the pressure-sensitive adhesion layer comprising a gel composition.

2. The pellicle according to Claim 1, wherein the gel composition has a 1/4 cone penetration in accordance with ASTM D-1403 of at least 50 but no greater than 100.

3. The pellicle according to Claim 1 or 2, wherein the pressure-sensitive adhesion layer has a thickness of at least 0.3 mm but no greater than 0.8 mm.

4. The pellicle according to any one of Claims 1 to 3, wherein the pressure-sensitive adhesion layer has a thickness of 0.3 to 0.5 mm.

5. The pellicle according to any one of Claims 1 to 4, wherein the gel composition is a synthetic polymer gel composition.

6. The pellicle according to any one of Claims 1 to 5, wherein the gel composition comprises a silicone polymer gel or a urethane polymer gel.

7. The pellicle according to Claim 6, wherein the gel composition comprises a silicone polymer gel.

8. The pellicle according to any one of Claims 1 to 7, wherein the gel composition comprises a two-component silicone polymer gel or urethane polymer gel.

9. The Pellicle according to any one of Claims 1 to 8, wherein the pellicle frame comprises an aluminum alloy.
